# EUROPEAN PATENT APPLICATION

(11) **EP 0 669 646 A1**
(43) Date of publication of application: **30.08.1995**
(21) Application number: 95102763.0
(22) Date of filing: 27.02.1995
(51) Int. Cl.: H01L 21/311

(54) **Improvements in or relating to semiconductor devices**

(30) Priority: 25.02.1994 JP 52744/94
(71) Applicant: TEXAS INSTRUMENTS INCORPORATED, Dallas Texas 75265 (US)
(72) Inventor: Goto, Hideto, Niihari-gun, Ibaraki-ken, 300-41 (JP); Nishimura, Michio, Tokorozawa-shi, Saitama-ken, 359 (JP); Moroi, Masayuki, Thuchiura-shi, Ibaraki-ken, 300 (JP)
(74) Representative: Schwepfinger, Karl-Heinz, Dipl.-Ing.

(57) **Abstract**

A manufacturing method of a semiconductor device, such as a dynamic RAM having fin-shaped, stacked cell capacitor in memory cell characterized by the following facts: first insulating layer (MTO layers (20), (28)) and second insulating layer (BPSG layers (21), (29)) are formed in order on a silicon semiconductor substrate (1); of them, at least the second insulating layer is subject to an etching processing step to manufacture the semiconductor device; the etching solution used in this manufacturing process contains 1.6-6 wt% of hydrogen fluoride and 2.5-10 wt% of ammonium fluoride.

Effect: The etching rate ratio of the first insulating layer and second insulating layer can be set appropriately, and the various layers can be etched with excellent controllability. In this way, the surface is flat after the etching processing, and a uniform etching operation can be performed.

## Description

### Industrial application field

This invention concerns a manufacturing method of semiconductor device (such as dynamic RAM having fin-shaped, stacked cell capacitors), and a type of etching solution used in the manufacturing method.

### Prior art

In the conventional method of manufacturing of semiconductor IC devices, interlayer oxide film made of oxide film formed by CVD (Chemical Vapor Deposition) method, low-temperature CVD oxide film known as MTO (Middle Temperature Oxide), and CVD oxide film known as BPSG (Boron Phosphor[sic]-doped Silicate Glass) are deposited on a silicon substrate, followed by dry etching for uniform etchback, so that the surface of the oxide film becomes flat.

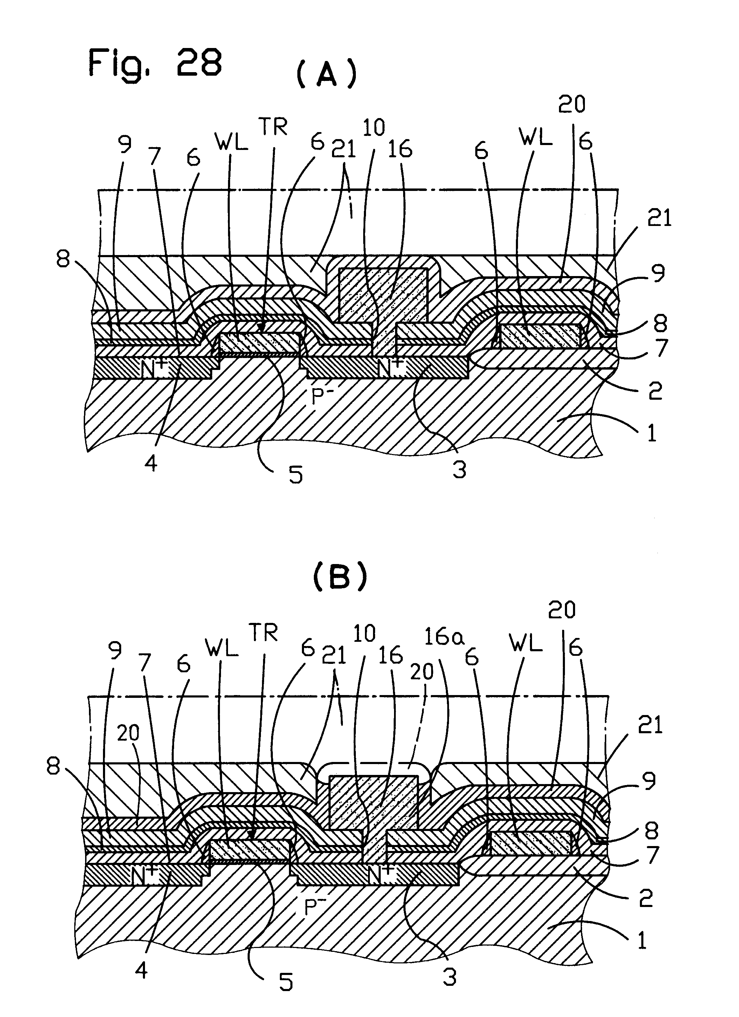

For example, as shown in Figure 28(A), in a processing step of the manufacture of the memory cell M-CEL of the dynamic RAM, polysilicon layer (16) as a portion of the lower electrode of the capacitor (in particular, fin-shaped, stacked cell capacitor with a large area of the dielectric film or capacitance) is connected to the n⁺⁻type source region (3) of transfer gate TR, MTO layer (20) for forming the fin portion (to be explained below) is coated on the polysilicon layer; then, a BPSG layer (21) for flattening the surface is laminated on it at the position indicated by the dotted-dashed line, followed by thermal reflow; then, the aforementioned BPSG layer is etched to the position indicated by the solid line, so that the surface becomes flat.

In the figure, (1) represents a p--type silicon substrate; (2) represents a field oxide film for element region isolation; (4) represents an n⁺⁻type drain region; (5) represents a gate oxide film; (6) represents an Si0₂ side wall; (7) represents an MTO layer for passivation; (8) represents an Sb N4 layer for protection of the underlayer; (9) represents an MTO layer for forming the fin portion (to be explained later); (10) represents a contact hole; WL represents a polysilicon word line.

However, during the aforementioned etchback processing step, if the ratio of the etching rate between the two types of oxide films (that is, BPSG layer (21) and MTO layer (20)) is not selected appropriately, it is difficult or even impossible to realize the objective of flattening.

That is, as explained above, for removal of the aforementioned interlayer insulating layer by means of the etchback process, compared with RIE (Reactive Ion Etching) or another dry etching method, the wet etching method is better with respect to the mass production and uniformity, and is thus often adopted. However, for the wet etching method, depending on the type of etching solution used in the process, there may be a significant difference in the etching rate between BPSG layer (21) and MTO layer (20), and the controllability of the process is degraded significantly. Since the controllability is poor, the following serious problems take place in practice.

For the conventionally used etching solution, for the aforementioned oxide films, because the etching rate on one of BPSG layer (21) and MTO layer (20) is too high, for example, if the etching rate of MTD layer (20) is too high, as shown in Figure 28(B), the principal portion of MTO layer (20) indicated by the broken line is etched off.

Consequently, for the portion corresponding to the MTO layer (20) removed by etching (indicated by the dotted line), it is necessary to deposit and form the MTO layer again. This is a disadvantage.

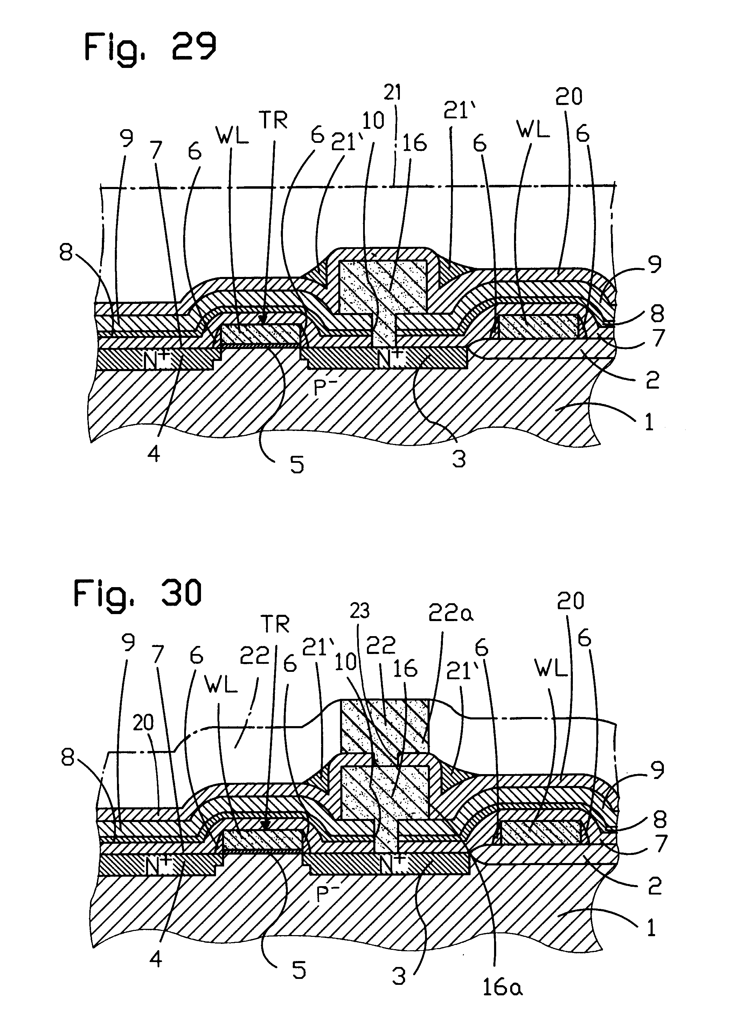

On the other hand, contrary to what was explained above, when the aforementioned etching solution has a much higher etching rate for BPSG layer (21) than for MTO layer (20), as shown in Figure 29, BPSG layer (21) is overetched, leading to significant dip/bump or step pattern on the surface, and the surface does not become flat, and etching residue (21') of BPSG is left on the step portion in the periphery of polysilicon layer (16).

As shown in Figure 30, due to presence of this step, MTO layer (9) is selectively removed by etching on polysilicon layer (16) to form through-hole (23). In this case, when polysilicon layer (22) is coated, although it is possible to form fin portions (16a), (22a), the overall dip/bump degree becomes larger for the surface of the memory cell, and problems may readily occur in subsequent processing steps, such as wiring of bit lines, etc.

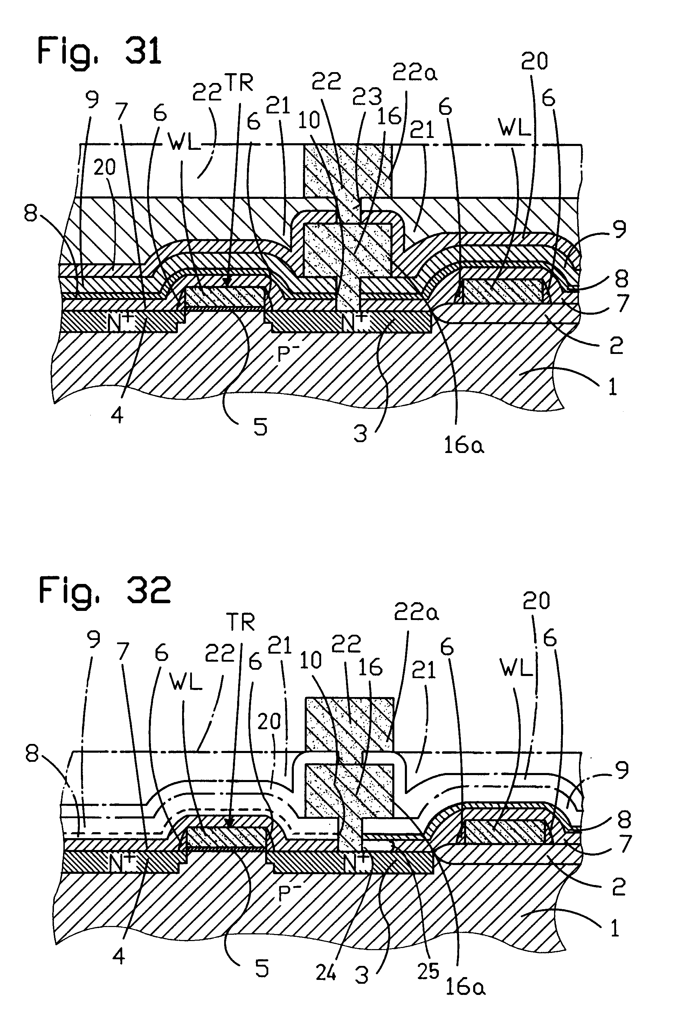

In order to solve the aforementioned problem, as shown in Figure 31, the aforementioned etching process, is performed appropriately to ensure that BPSG layer (21) remaining on polysilicon layer (16). However, in this case, although the surface becomes flat, the height of the capacitor is increased, this is apt to cause problems in bit line wiring and subsequent processing steps.

On the other hand, in order to form the fin structure of the capacitor, as shown in Figure 32, with polysilicon layers (16) and (22) laminated in the aforementioned manner, BPSG layer (21), MTO layers (20) and (9) are removed sequentially by etching. However, in this case, as was explained above, there is a significant difference in the etching rate of the etching solution used between BPSG layer (21) and MTO layer (20). Consequently, the following major problems take place.

That is, when the etching rate of the MTO layer is too high, as indicated by arrow (24), the etching solution penetrates into the interface between polysilicon layer (16) and Si₃N₄ layer (nitride layer) (8), and MTO layer (7) is thus partially etched off in the lower portion of Si₃N₄ layer (8), forming voids (25) there.

Also, the etching selection ratio of the etching solution for Si₃N₄ layer (8) is insufficient depending on the etching solutions, and, since the thickness of Sb N4 layer (8) is made as small as possible, Sb N4 layer (8) itself is etched away as indicated by the broken line in Figure 32. As a result, there is the danger that oxide film (MTO layer) (7) on the gate's polysilicon word line WL may be etched off.

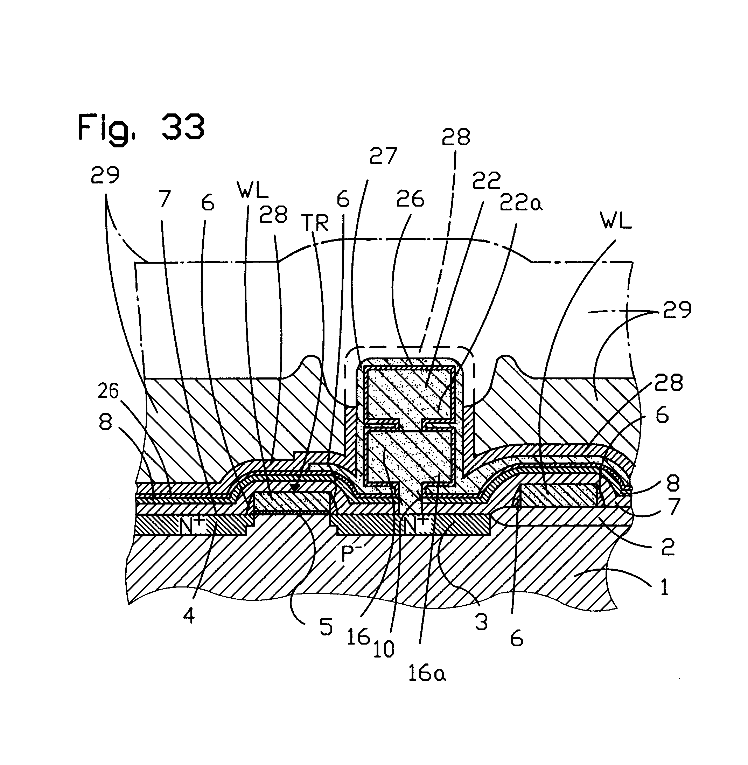

In addition, as explained above, after BPSG layer (22), MTO layers (20) and (9) are etched off as explained above, as shown in Figure 33, after a dielectric film (26) made of Sb N4 is deposited on the surface of polysilicon layers (22) and (16) including fin parts (22a) and (16a) by means of CVD, a polysilicon layer (27) to he used as the upper electrode is formed by CVD on the surface, followed by processing to the prescribed pattern. Then, MTO layer (28) is deposited on the entire surface, and BPSG layer (29) is deposited to the position indicated by dotted-dashed line, followed by etchback of said BPSG layer (29).

However, the same problems as above take place during the etchback processing. For example, when the etching rate of MTO layer (28) by the etching solution is much higher than that of BPSG layer (29), just as what was explained with reference to Figure 28(B), the principal portion of MTO layer (28) is etched off as indicated by the broken line.

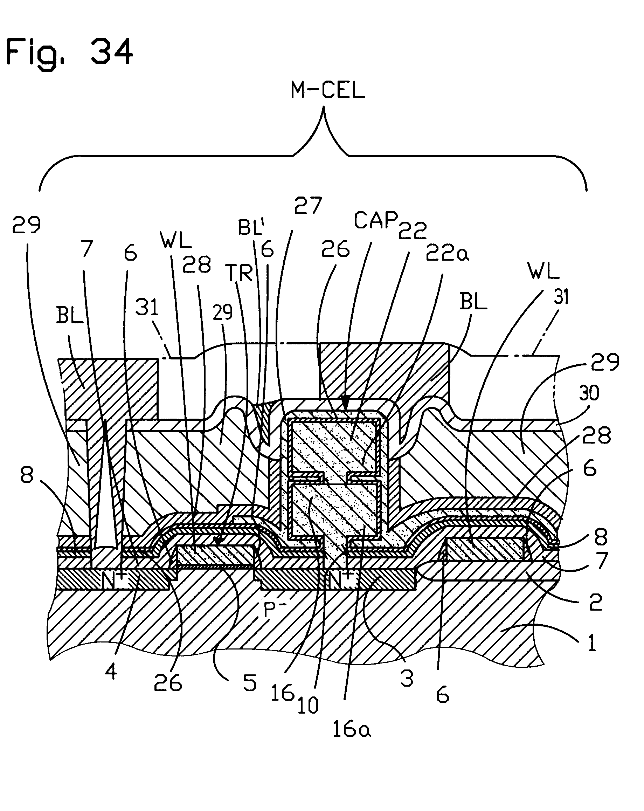

As a result, a significant step is generated on the periphery of polysilicon layer (22). As shown in Figure 34, due to MTO layer (30), a step is left due to burying of the layer. When the bit lines BL are to be formed by etching the prescribed pattern for electroconductive layer (31) by sputtering a coating on MTO layer (30), the aforementioned step makes processing difficult. Also, after the processing, residue BL' of the electroconductive material is left, and as the amount of the residue is large, short- circuiting may take place between wires.

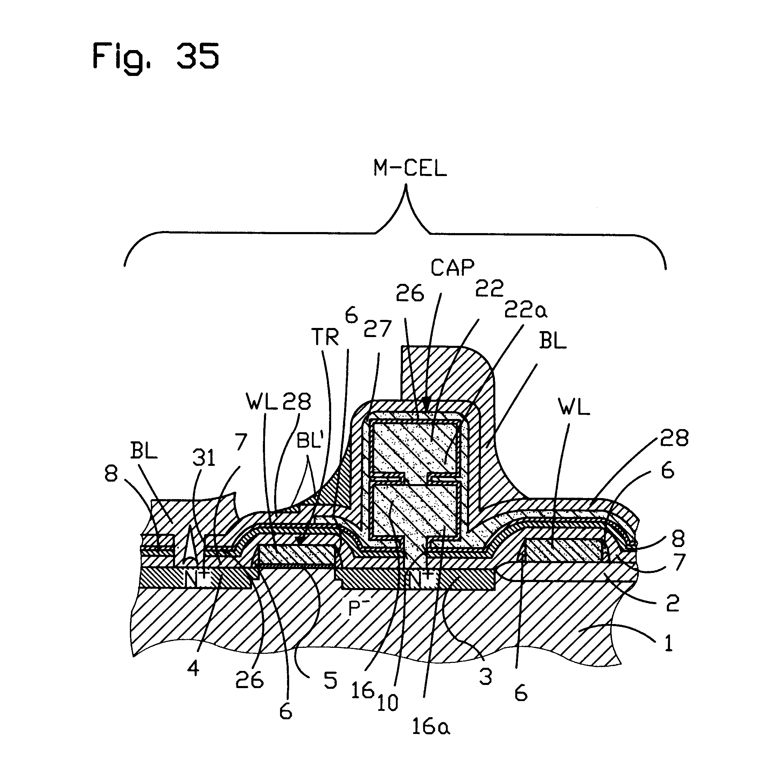

Contrary to what was explained above, when the etching rate of BPSG layer (29) is too high, the same phenomenon as shown in Figure 29 takes place, and significant collapse takes place for the flatness of the surface after etching of BPSG layer (29), as shown in Figure 35. Consequently, the height of capacitor CAP is too large, causing problems in the wiring stage of bit lines, etc. Also, there is a large amount of etching residue BL'.

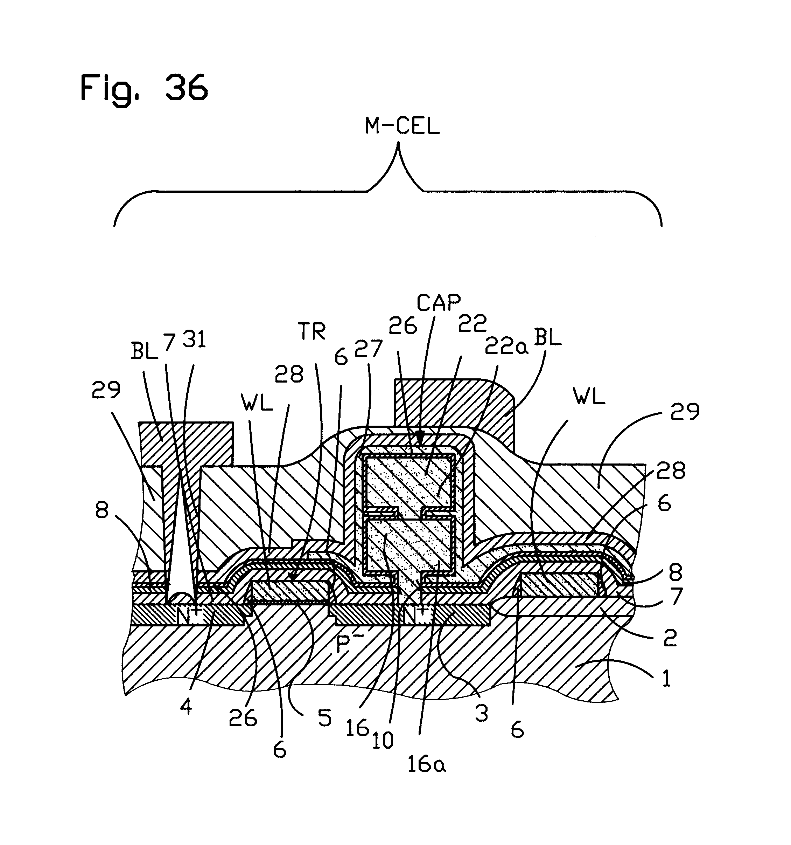

In order to eliminate the problem caused by the step, as shown in Figure 36, when etchback of BPSG layer (29) is suppressed, BPSG layer (29) after etching is left on the entire region on the cell, including capacitor CAP. In this state, the thickness of the interlayer insulating film in the contact area of bit line BL becomes rather large. As a result, the contact hole (31) on n⁺⁻type drain region (4) becomes deeper. In this contact hole, the step coverage of the electroconductive electrode material for bit lines becomes poor, and wire breakage shown in the figure may readily occur.

### Problem to be solved by the invention

The purpose of this invention is to provide a manufacturing method of dynamic RAM or other semiconductor device characterized by the fact that multiple interlayer insulating layers can be etched with excellent controllability with the desired etching rate ratio, the elements with the desired shape (such as the aforementioned fin-shaped, stacked cell capacitor) can be processed, and the surface flatness and the step coverage property can be improved, as well as a type of etching solution used in implementing the manufacturing method.

### Means for solving the problems

That is, this invention provides a manufacturing method of semiconductor device characterized by the following facts: a first insulating layer and a second insulating layer are formed in order on a semiconductor substrate; there is a processing step in which at least the second insulating layer is etched; in this manufacturing method of a semiconductor device, an etching solution containing 1.6-6 wt% of hydrogen fluoride and 2.5-10 wt% of ammonium fluoride is used in the aforementioned etching processing step.

According to the manufacturing method of this invention, when the first insulating layer is formed from a low-temperature grown silicon oxide (such as said MTO), and the second insulating layer is formed from boron and/or phosphorus-containing silicon oxide (such as said BPSG), by selecting the aforementioned etching solution within the aforementioned composition (with respect to the total amount of the etching solution, the content of hydrogen fluoride (HF) is in the range of 1.6-6 wt% and the content of ammonium fluoride (NH4.F) is in the range of 2.5-10 wt%), it is possible to set appropriately the etching rate ratio between the first and second insulating layers (interlayer insulating layers) made of silicon oxide, and the various films can be etched with good controllability.

In particular, it is possible to select the ratio of amount of HF and NH4 in an appropriate manner to ensure that the etching rate of the second insulating layer is greater than or equal to the etching rate of the first insulating layer by a prescribed margin. Consequently, when etching of the first insulating layer is performed after etching of the second insulating layer, and when the second insulating layer is etched back for flattening, the various layers can be etched at appropriate rates, and it is possible to prevent the aforementioned problem that etching of the lower layer progresses too fast when etching is performed for the upper layer.

For example, when the capacitor is formed on the memory cell, as the interlayer insulating layer of the capacitor, the first insulating layer is formed; then, the second insulating layer is formed on the first insulating layer, and at least the second insulating layer is etched.

More specifically, this invention is effective for the manufacturing method of a semiconductor device (such as a dynamic RAM characterized by the fact that when the second electroconductive layer (such as a polysilicon layer) is laminated as the lower electrode on the first electroconductive layer (such as the polysilicon layer) so as to form a stacked cell capacitor, there are the following processing steps:
processing step in which a first insulating layer and a second insulating layer are formed in order on the aforementioned first electroconductive layer;
processing step in which the aforementioned second insulating layer is etched to become flat, while the aforementioned first insulating layer is exposed on the aforementioned first electroconductive layer;
processing step in which the exposed first insulating layer is removed selectively, and the aforementioned second electroconductive layer is formed on the aforementioned removal region;
processing step in which the aforementioned second insulating layer and the aforementioned first insulating layer are etched after the aforementioned processing step;
processing step in which after the etching process, a dielectric film is formed on the surface of the aforementioned first electroconductive layer and the aforementioned second electroconductive layer (for example, formation of Sb N4 layer, or a portion of Sb N4 layer is taken as the oxide film);
processing step in which a third electroconductive layer (such as a polysilicon layer) is formed as the upper electrode on the aforementioned dielectric film;
processing step in which the aforementioned first insulating layer and the aforementioned second insulating layer are formed in order on the aforementioned third electroconductive layer;
and processing step in which the second insulating layer is etched to become flat.

Or, this invention is effective in the manufacturing method of a semiconductor device (such as a dynamic RAM) characterized by the fact that when the cell capacitor is formed with only the first electroconductive layer used as the lower electrode, there are the following processing steps:
processing step in which a dielectric film is formed on the aforementioned first electroconductive layer;
processing step in which an upper electrode is formed on the aforementioned dielectric film;
processing step in which the first insulating layer and second insulating layer are formed in order on the aforementioned upper electrode;
and processing step in which the second insulating layer is etched to become flat.

In the aforementioned manufacturing methods, when the cell capacitor is formed with a fin shape, it is possible to form the aforementioned first insulating layer directly beneath the fin portion of the aforementioned first electroconductive layer.

While the aforementioned first electroconductive layer is connected to the source region of the memory cell, the aforementioned first insulating layer and the aforementioned second insulating layer on the upper electrode are also formed on the drain region, and contact hole is formed in the insulating layers including the aforementioned first insulating layer and the aforementioned second insulating layer on the drain region.

This invention also provides a type of etching solution characterized by the fact that in the aforementioned manufacturing method, the etching solution is used at least for etching the aforementioned second insulating layer, and that it contains 1.6-6 wt% of hydrogen fluoride, and 2.5-10 wt% of ammonium fluoride.

Reference will now he made, by way of example, to the accompanying drawings, in which:-
(Figure 1) It is a graph illustrating the etching rate of buffered hydrofluoric acid as a function of the concentration of NH4 (with the HF concentration held constant at 6.0 wt%).
(Figure 2) It is a graph illustrating the etching rate of buffered hydrofluoric acid as a function of the concentration of NH4 (with the HF concentration held constant at 1.6 wt%).
(Figure 3) It is a graph illustrating the etching rate of buffered hydrofluoric acid as a function of the concentration of HF (with the NH4 held constant at 6.0 wt%).
(Figure 4) It is a graph illustrating the etching rate of buffered hydrofluoric acid as a function of the concentration of NH4 (with the HF concentration held constant at 0.5 wt%).
(Figure 5) It is a graph illustrating the etching rate of buffered hydrofluoric acid as a function of the concentration of NH4 (with the HF concentration held constant at 4.0 wt%).
(Figure 6) It is a graph illustrating the etching rate of buffered hydrofluoric acid as a function of the concentration of NH4 (with the HF concentration held constant at 8.0 wt%).
(Figure 7) It is an enlarged cross-sectional view illustrating a processing step of the manufacturing method of a dynamic RAM memory cell according to this invention.
(Figure 8) It is an enlarged cross-sectional view illustrating another processing step in the aforementioned manufacturing method of the memory cell.
(Figure 9) It is an enlarged cross-sectional view illustrating another processing step in the aforementioned manufacturing method of the memory cell.
(Figure 10) It is an enlarged cross-sectional view illustrating another processing step in the aforementioned manufacturing method of the memory cell.
(Figure 11) It is an enlarged cross-sectional view illustrating another processing step in the aforementioned manufacturing method of the memory cell.
(Figure 12) It is an enlarged cross-sectional view illustrating another processing step in the aforementioned manufacturing method of the memory cell.
(Figure 13) It is an enlarged cross-sectional view illustrating another processing step in the aforementioned manufacturing method of the memory cell.
(Figure 14) It is an enlarged cross-sectional view illustrating another processing step in the aforementioned manufacturing method of the memory cell.
(Figure 15) It is an enlarged cross-sectional view illustrating another processing step in the aforementioned manufacturing method of the memory cell.
(Figure 16) It is an enlarged cross-sectional view illustrating another processing step in the aforementioned manufacturing method of the memory cell.
(Figure 17) It is an enlarged cross-sectional view illustrating another processing step in the aforementioned manufacturing method of the memory cell.
(Figure 18) It is an enlarged cross-sectional view illustrating another processing step in the aforementioned manufacturing method of the memory cell.
(Figure 19) It is an enlarged cross-sectional view illustrating another processing step in the aforementioned manufacturing method of the memory cell (corresponding to the cross-sectional view along line XIX-XIX of Figure 20).
(Figure 20) It is a plan view of the aforementioned memory cell.
(Figure 21) It is an enlarged cross-sectional view illustrating a processing step of the manufacturing method of another type of dynamic RAM according to this invention.
(Figure 22) It is an enlarged cross-sectional view illustrating another processing step of the manufacturing method of the aforementioned memory cell.
(Figure 23) It is an enlarged cross-sectional view illustrating another processing step of the manufacturing method of the aforementioned memory cell.
(Figure 24) It is an enlarged cross-sectional view illustrating another processing step of the manufacturing method of the aforementioned memory cell.
(Figure 25) It is an enlarged cross-sectional view illustrating another processing step of the manufacturing method of the aforementioned memory cell.
(Figure 26) It is an enlarged cross-sectional view illustrating another processing step of the manufacturing method of the aforementioned memory cell.
(Figure 27) It is an enlarged cross-sectional view illustrating another processing step of the manufacturing method of the aforementioned memory cell.
(Figure 28) It shows an enlarged cross-sectional view (A) illustrating a processing step of the manufacturing method of the memory cell of a conventional dynamic RAM, and an enlarged cross-sectional view (B) illustrating the problems that take place in this processing step.
(Figure 29) It is an enlarged cross-sectional view illustrating the problems that take place in the processing step shown in Figure 28 in the manufacturing method of the memory cell.
(Figure 30) It is an enlarged cross-sectional view illustrating the problems that take place in the processing step in the manufacturing method of the memory cell.
(Figure 31) It is an enlarged cross-sectional view illustrating the problems that take place in the processing step in the manufacturing method of the memory cell.
(Figure 32) It is an enlarged cross-sectional view illustrating the problems that take place in another processing step in the manufacturing method of the memory cell.
(Figure 33) It is an enlarged cross-sectional view illustrating the problems that take place in another processing step in the manufacturing method of the memory cell.
(Figure 34) It is an enlarged cross-sectional view illustrating the problems that take place in another processing step in the manufacturing method of the memory cell.
(Figure 35) It is an enlarged cross-sectional view illustrating the problems that take place in the processing step illustrated in Figure 34 in the manufacturing method of the memory cell.
(Figure 36) It is an enlarged cross-sectional view illustrating the problems that take place in the processing step illustrated in Figure 34 in the manufacturing method of the memory cell.

### Application examples

In the following, this invention will be explained in more detail with reference to application examples.

As explained above, for the interlayer insulating layer having a laminated configuration made of MTO layer (first insulating layer) and BPSG layer (second insulating layer), when etching is performed for the BPSG layer and then for the MTO layer, the wet etching method is appropriate for the etching process with respect to the mass production and uniformity. The present inventors extensively studied buffered hydrofluoric acid with NH4 added with respect to HF as components of the etching solution (etchant) used in the etching process.

As a result of this invention, by appropriately selecting the composition of the buffered hydrofluoric acid (by means of concentration control), the desired etching rate ratio and selectivity for the BPSG layer and MTO layer can be obtained, and the ratios can be controlled over relatively wide ranges. For this point, a more detailed explanation will be presented in the following, including the experimental results.

First of all, when an aqueous solution containing 5 wt% of hydrogen fluoride (HF) alone is used as the etching solution for etching the aforementioned laminate film, the etching rate for the BPSG layer is higher than that of the MTO layer by about 4-5 times.

On the other hand, when ammonium fluoride (NH4.F) is added to the etching solution, the buffered hydrofluoric acid containing 6 wt% of HF and 30% of NH4 is used as the etching solution, the aforementioned etching rate ratio is inverted, that is, the etching rate for the MTO layer is higher than that of the BPSG layer by about 2 times.

Based on the aforementioned finding, the present inventors have checked the variation in the etching rates for BPSG layer and MTO layer when the contents of HF and NH4 in the buffered hydrofluoric acid are adjusted.

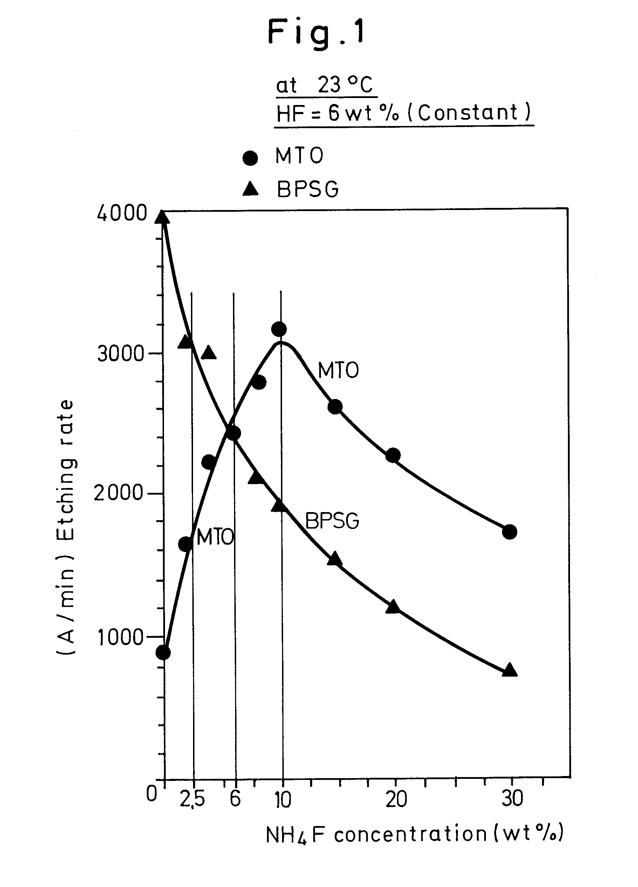

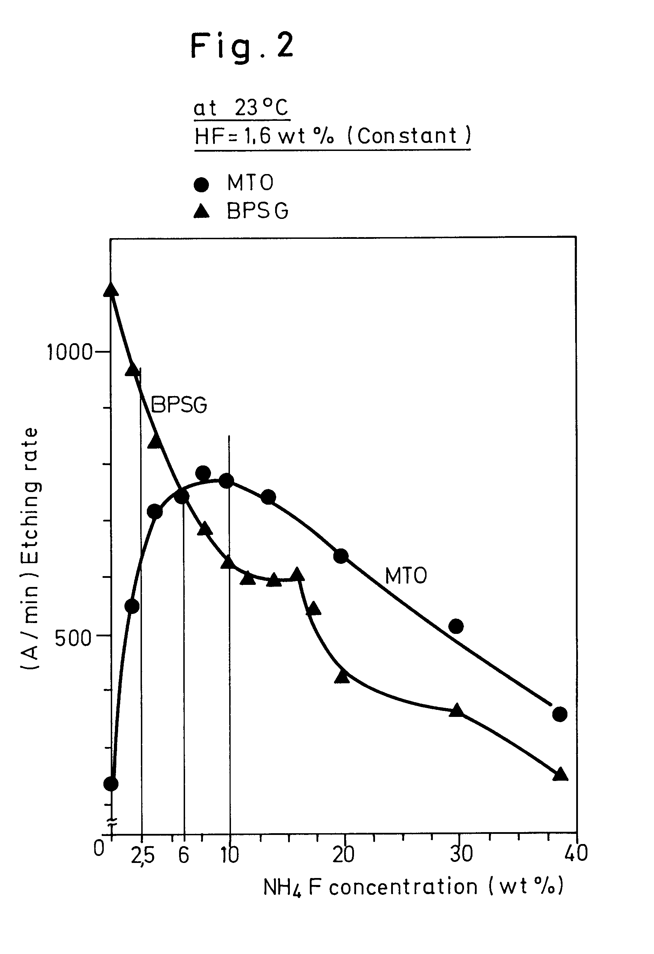

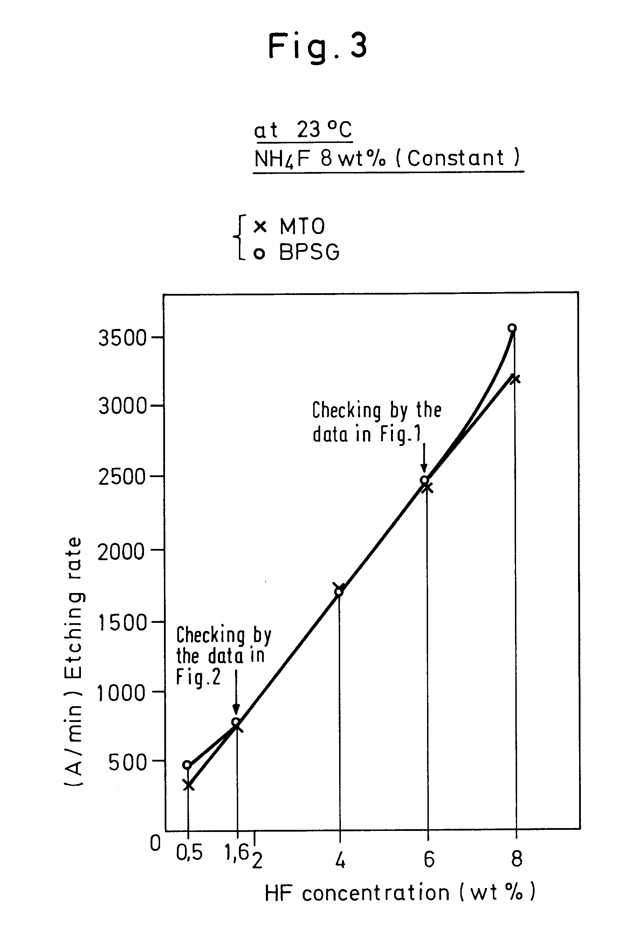

For example, when the HF concentration is fixed at 6 wt%, while the concentration of NH₄F is varied, as shown in Figure 1, the etching rates of BPSG layer and MTO layer are inverted with respect to each other when the concentration of NH₄F becomes about 6 wt%.

That is, when the concentration of NH4 drops to about 6 wt% or lower, as the concentration decreases, the etching rate for the BPSG layer rises, while the etching rate for MTO layer decreases, leading to an increase in the difference between these etching rates. This difference reaches a maximum when the concentration of N H₄ becomes 0 wt%. On the other hand, when the concentration of NH4 becomes about 6 wt% or larger, the etching rate ratio is inverted, with the etching rate for the MTO layer becoming larger. Before the content of NH₄F becomes 10 wt%, as the etching rate of MTO layer rises, the etching rate of BPSG layer drops. Then, when the concentration of NH₄F rises above 10 wt%, while the difference between the two etching rates remains almost constant, both etching rates decrease, and the difference in the etching rate is maintained even under the aforementioned condition that HF = 6 wt% and NH₄F = 30 wt%.

For the etching solution containing HF alone (referred to as Comparative Composition 1 hereinafter), etching for BPSG layer becomes excessive, and the problems explained with reference to Figures 29, 30, and 35 (that is, surface step and etching residue) cannot be avoided. For the etching solution containing 6 wt% of HF and 30 wt% of NH4 (referred to as Comparative Composition 2 hereinafter), the etching of the MTO layer is excessive, and the problems explained with reference to Figures 28(B) and 32-34 (increase in the number of stages of formation of film, surface steps and etching residue, voids in passivation film) cannot be avoided.

In order to solve the problems encountered for etching solutions with Comparative Composition 1 and Comparative Composition 2, it is necessary to have appropriate etching rate ratio or etching rate difference (selectivity) between the BPSG layer and MTO layer. In order to realize the purpose of this invention, it is very important to select appropriately the composition of the buffered hydrofluoric acid to ensure that the etching rate difference is smaller than the etching rate difference between BPSG layer and MTO layer, that is, with concentration of NH4 of 10 wt% or smaller. Also, judging from the aforementioned problem, there is the significant disadvantage that the MTO layer is overetched. Consequently, it is also important to ensure that the etching difference between MTO layer and BPSG layer is smaller than the etching rate difference when NH₄F = 10 wt%, while the etching rate for the MTO layer does not drop more than what is needed. From this point of view, it is necessary to have an NH4 concentration of 2.5 wt% or higher.

Then, with the concentration of HF decreased to 1.6 wt%, the same experiment was performed as above. As shown in Figure 2, just as with the aforementioned experiment, when the concentration of NH4 is about 6 wt%, inversion of the etching rates of BPSG layer and MTO layer took place. From this result, it can be seen that even when the HF concentration is low, a appropriate etching rate ratio of BPSG layer and MTO layer can still be obtained when the NH4 concentration is higher than 2.5 wt% and lower than 10 wt%.

Then, the experiment was performed as follows. The purpose is to find the range of variation of the etching rates of BPSG layer and MTO layer when the HF concentration is varied while the concentration of NH4 is fixed at 6 wt%. As shown in Figure 3, it can be seen that [the aforementioned etching rates) are equal to each other when the HF concentration is in the range of 1.6-6 wt%. There has been no other report on this phenomenon. This finding by the present inventors is unprecedented.

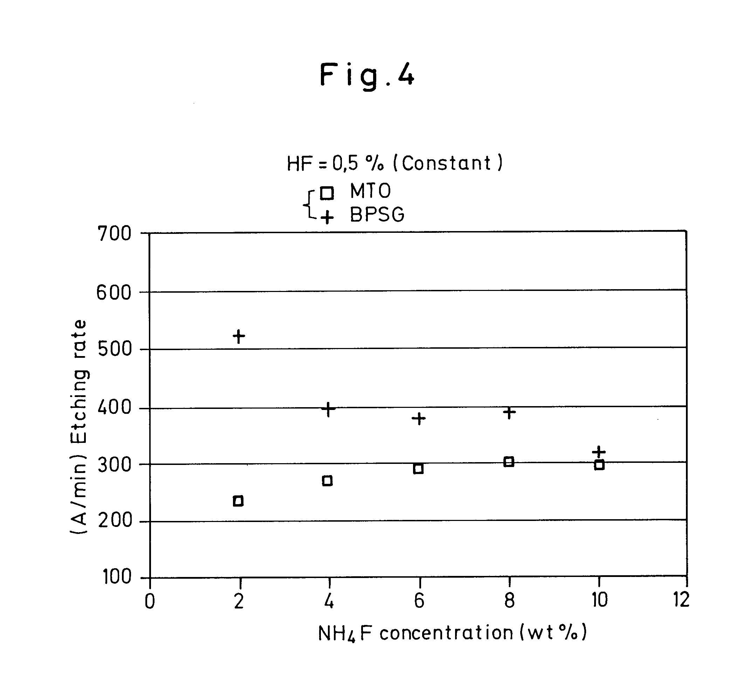

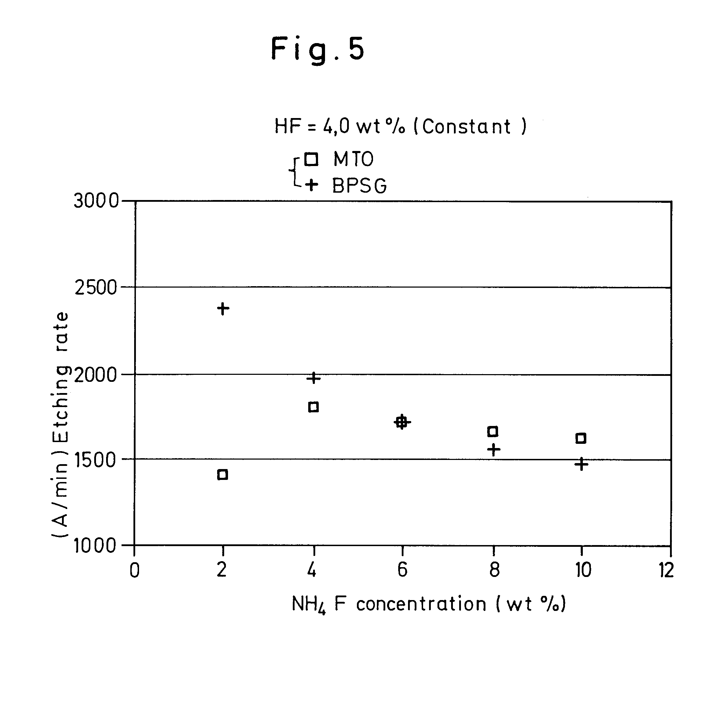

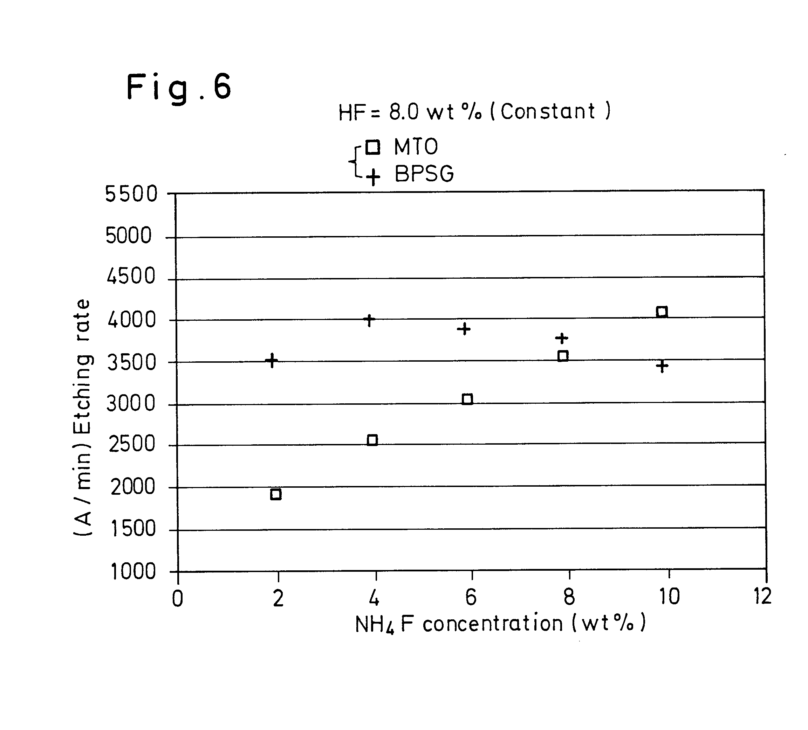

For this phenomenon, as shown in the examples illustrated in Figures 4-6, when the HF concentration is fixed at 0.5 wt% (Figure 4), 4.0 wt% (Figure 5), and 8.0 wt% (Figure 6), as the concentration of NH4 varies, although there is a certain error compared with the data shown in Figure 3, the results obtained nearly correspond to Figure 3. In particular, when HF = 4.0 wt%, the etching rates for the BPSG layer and MTO layer become identical. This is a useful finding.

Based on the aforementioned experimental results, when etching is to he performed for the laminate film of BPSG and MTO, in order to etch BPSG without affecting the underlying MTO layer so as realize surface flatness, to make a free selection of the etching rates of the two layers (with the etching rate ratio of BPSG/MTO in the range of 0.6-0.8), to etch MTO layer appropriately (with an appropriate etching rate difference from that for nitride), and to etch the interlayer insulating layers with high uniformity, this invention dictates that it is necessary to use a buffered hydrofluoric acid with a basic composition of
HF = 1.6-6 wt%
NH₄F = 2.5-10 wt%
(water may be used as the solvent) as the etching solution.

For this basic composition, in consideration of the etching rate ratio of BPSG layer and MTO layer, in order to further ensure the aforementioned effect, it is preferred that the composition be HF = 2-5 wt% and NH4 = 3-8 wt%. In particular, the composition at which the etching rate for the BPSG layer is identical to that for the MTO layer, such as the composition with HF = 1.6-6 wt% (or preferably 2-5 wt%) and NH₄F = 6 wt%, is desired.

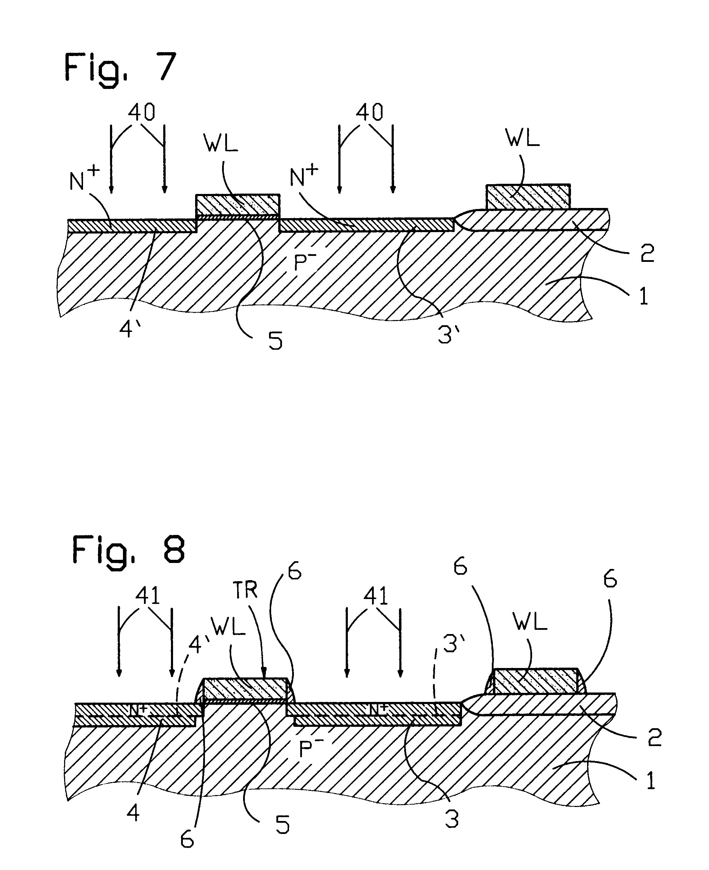

In the following, an example of the method for preparing the dynamic RAM memory cell by using the aforementioned etching solution will be presented with reference to Figures 7-20.

First of all, as shown in Figure 7, field Si0₂ film (2) is formed selectively on a principal surface of a p--type silicon substrate (1) using the conventional LOCOS method. Then, gate oxide film (5) is formed using the thermal oxidation method. The first layer of polysilicon is deposited using the CVD method. It is processed to form the polysilicon word line WL by patterning using the photoetching method. Then, with word line WL used as the mask, n-type impurity (such as arsenic or phosphorus) (40) is implanted into silicon substrate (1) using the ion implantation method, and n⁺⁻type semiconductor regions (3') and (4') are formed using the self-alignment method.

Then, as shown in Figure 8, the conventional sidewall technology is adopted to etchback the insulating layer (such as the Si0₂ layer) deposited on the entire surface using the CVD method, forming Si0₂ sidewall (6) selectively on the side surface of word line WL. Then, with word line WL and sidewall (6) used as the masks, n-type impurity (such as arsenic or phosphorus) (41) is implanted using the ion implantation method into said n⁺⁻type source regions (3') and (4') in a stacked manner with relatively large depth, and n⁺⁻type source region (3) and n⁺⁻type drain region (4) are formed using the self-alignment method. In this way, transfer gate TR is formed.

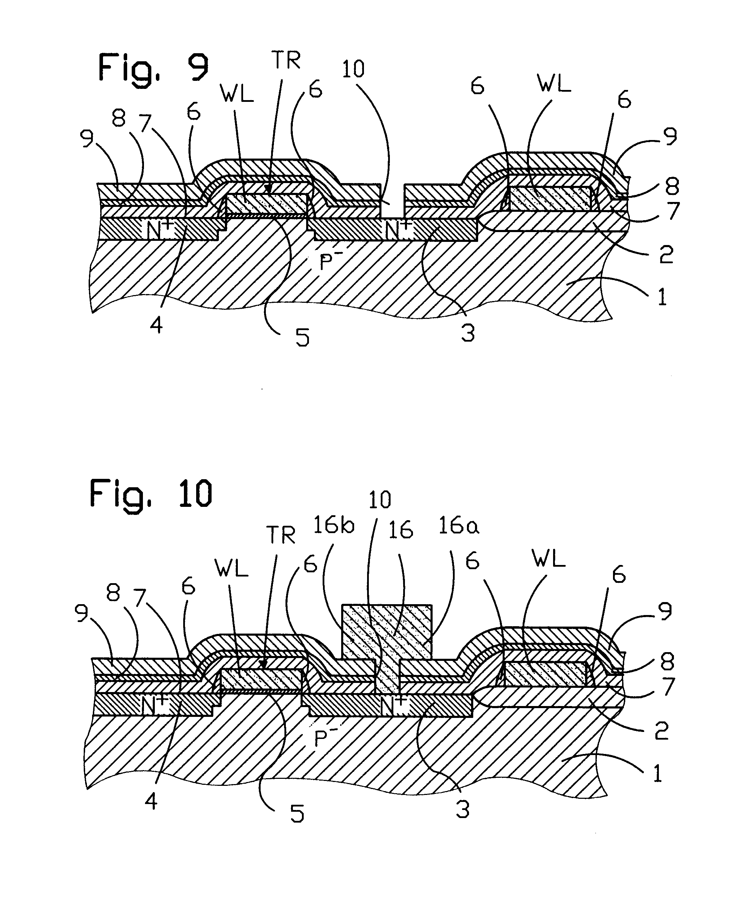

Then, as shown in Figure 9, on the surface of silicon substrate (1), Si02 layer (7) for passivation, Si₃N₄ layer (8) for protection of the base layer, and Si0₂ layer (9) for forming the fin portion are laminated in order, and a portion of the laminate film on n⁺⁻type source region (3) is selectively removed by stack-cutting using dry etching forming contact hole (10).

Here, Si0₂ layers (7) and (9) may be made of MTO (Middle Temperature Oxide) by means of low temperature CVD, as explained above. For example, these layers may be formed to a thickness of about 500 A under the following conditions.

Gas flow rate (volumetric ratio): SiH₄ = N₂0 = 1:10
(SiH₄ = 300 sccm, N₂0 = 3000 sccm Pressure: 0.001 atm
Temperature: 400-800 _{°} C
In addition, said Si₃N₄ layer (8) may be formed to a thickness of about 200 A using the CVD method. Also, the conventional RIE (Reaction Ion Etching) method may be adopted for forming said contact hole (10).

Then, as shown in Figure 10, the photoetching method is adopted for forming the pattern on the second layer of polysilicon deposited on the entire surface using the CVD method, with portions left selectively so that connection is made with the n⁺⁻ type region coated on contact hole (10), forming a portion of the lower electrode of the cell capacitor. The thickness of this polysilicon layer (16) is, for example, about 4500 Å, and it is 3000 A from the surface of MTO layer (9) (the thickness of fin portion (16a)).

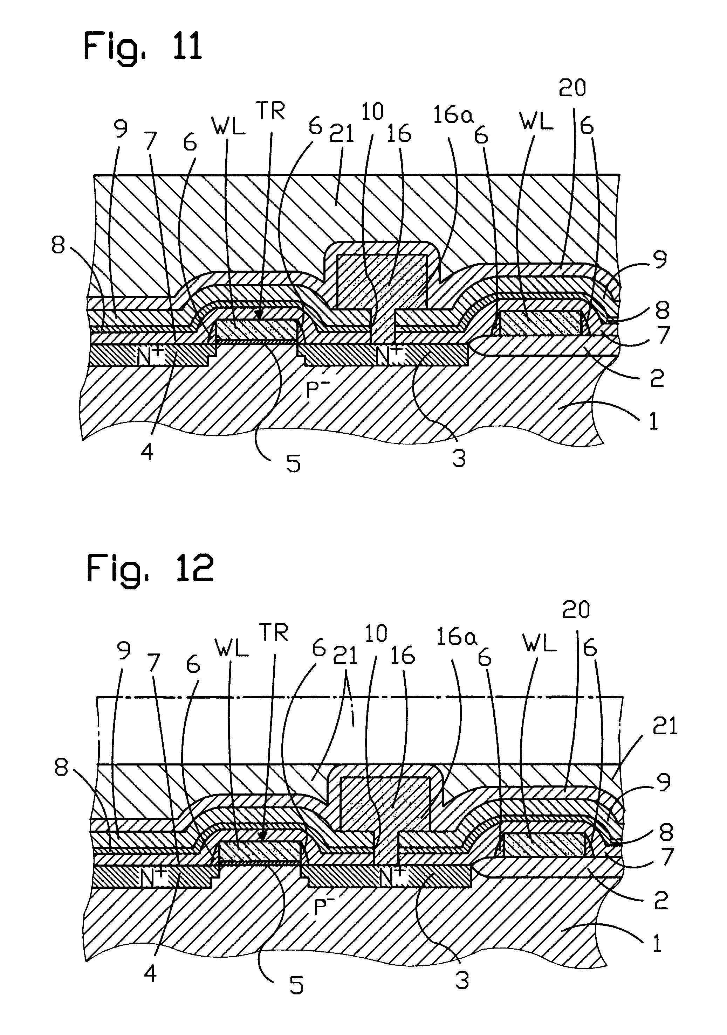

Then, as shown in Figure 11, under the same conditions as above, MTO layer (20) with a thickness of, say, 500 A is deposited on the entire surface. Then, for example, under the following listed conditions, said BPSG (Boron Phosphor-doped Silicate Glass) layer (21) is deposited to a thickness of about 7,000 Å. After deposition of the BPSG layer, thermal reflow processing is performed under the following conditions to make the surface flat. Intrinsically, reflow can facilitate flattening of the surface so as to form a finished surface free of steps. This is preferable for realizing a higher IC integration level.

Gas flow rate: SiH₄: 0₂: B₂H₆: PH₃ = 10:1000: 1:2
Pressure: 1 atm
Temperature: 400-500 °C

Thermal reflow conditions:
Temperature: 800-900 °C
Time: 5-20 min

Then, as shown in Figure 12, according to this invention, the aforementioned buffered hydrofluoric acid (HF= 6 wt%, NH₄F = 5-6 wt%) is used to etchback BPSG layer (21) at room temperature for a time in the range of 1.5-2 min, such as for 2 min. As a result, on the level indicated by the solid line, BPSG layer (21) is left with the largest thickness of 4000 Å, and MTO layer (20) is exposed on polysilicon layer (16).

In this case, for the etching solution, the composition is controlled as above. Consequently, the etching rate for BPSG layer (21) is about 1.1-1.2 times the etching rate for MTO layer (20) (for example, the etching rate for the BPSG layer is about 2550 A/min, and the etching rate for the MTO layer is about 2250 A/min.) (See Figure 1) As a result, even when BPSG layer (21) is thick, sufficient selective etchback can be made, the etched surface can be maintained flat, and it is possible to ensure reliable exposure of MTO layer (20) on polysilicon layer (16), while MTO layer (20) is substantially not etched under the control.

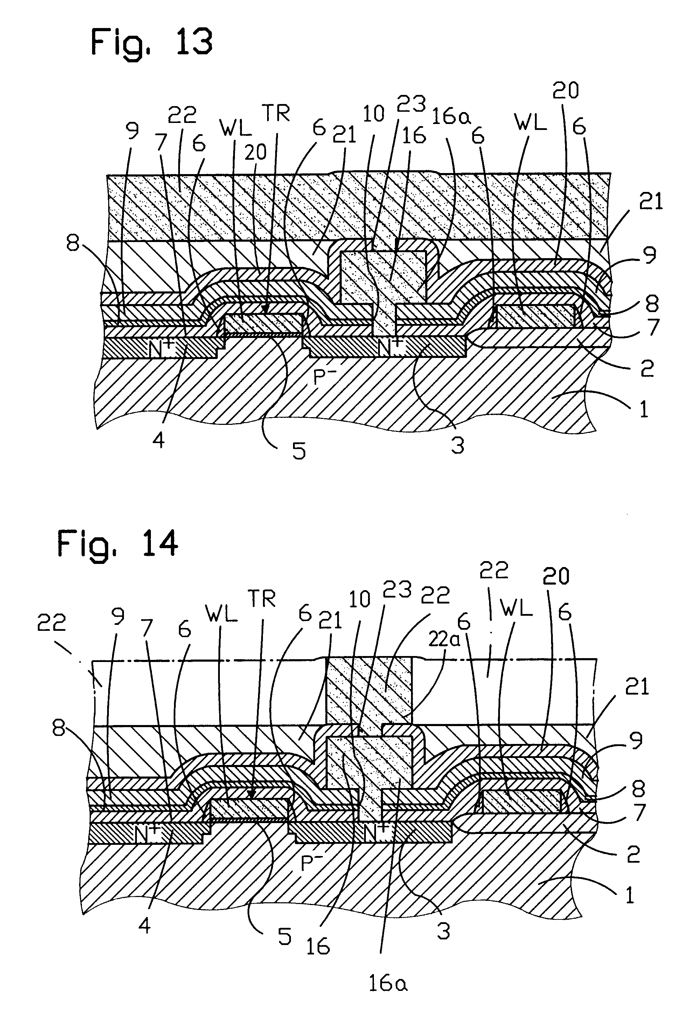

Then, as shown in Figure 13, a portion of MTO layer (20) on polysilicon layer (16) is removed by photoetching to form through-hole (23). In addition, by using a CVD method, a third layer of polysilicon (22) with a thickness of, say, 3000 A is deposited on the entire surface.

Then, as shown in Figure 14, by means of photoetching, polysilicon layer (22) is processed to a pattern substantially identical to that of polysilicon layer (16) as the lower layer, and it is laminated as a portion of the lower electrode of the capacitor, with connection made to polysilicon layer (16) via through-hole (23).

In this case, when etching of polysilicon layer (22) is performed, as explained with reference to Figure 12, etching of BPSG layer (21) can be performed with high quality, with a flat surface. Consequently, it is possible to suppress the step between MTO layer (20) and BPSG layer (21) to a minimum. In this way, the following excellent effects can be realized.
(1) In the photoetching (photolithography) performed for processing polysilicon layer (22), it is possible to improve the quality of processing of the mask (photoresist) and its alignment, to improve the focus depth and resolution in exposure, and to increase the margin at the time of processing. Consequently, it is appropriate for micron processing.
(2) When polysilicon layer (22) is dry-etched, the step can be minimized. Consequently, the amount of the etching residue left at the step portion can he reduced significantly or entirely eliminated. Consequently, the etching margin can be increased, and this corresponds well to an increase in the integration level of the device manufactured.
(3) Since BPSG layer (21) can he etched to the maximum limit until the surface of MTO layer
(20) is reached, it is possible to reduce the height of polysilicon layer (22) (in particular, its fin portion (22a)), so that the subsequent wiring process can be performed easily, and the processing margin can be increased.

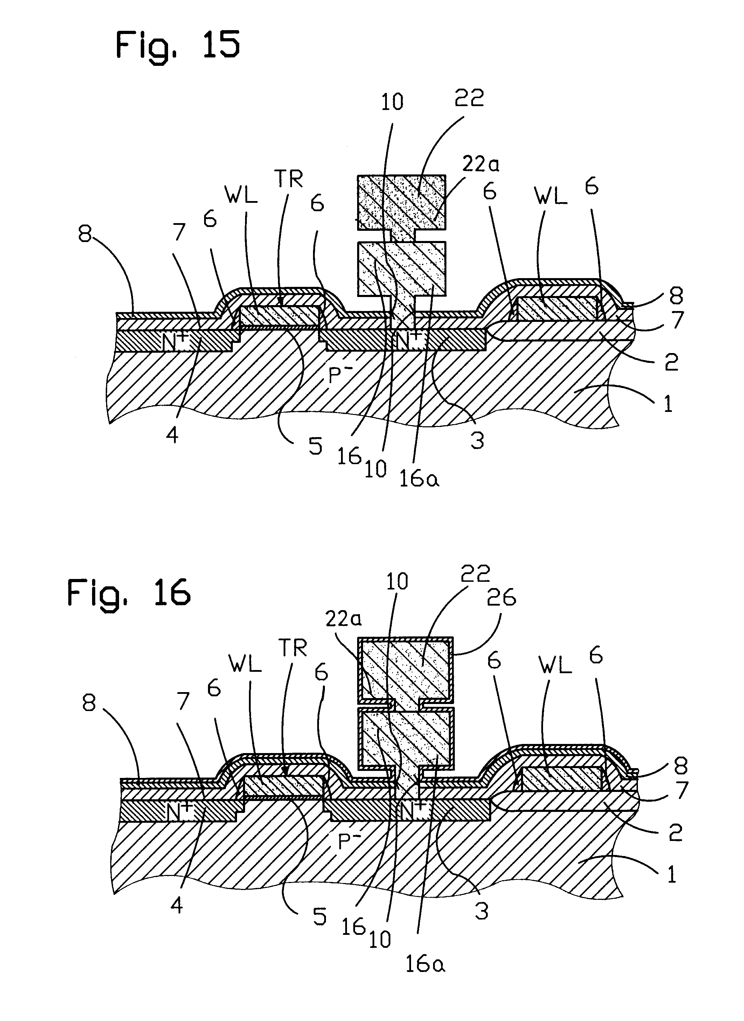

In this way, after the good etching processing for polysilicon layer (22), as shown in Figure 15, the aforementioned buffered hydrofluoric acid of this invention is used again for sequentially etching BPSG layer (21), MTO layer (20), and MTO layer (9) at room temperature for 2.5-4 min, such as 3 min, forming fin portions (16a) and (22a) on polysilicon layers (16) and (22) (that is, the lower electrode of the capacitor) by making appropriate processing for the lower electrode of the fin-shaped, stacked structure.

In this case, as the buffered hydrofluoric acid used has an etching rate for the BPSG layer higher than that for the MTO layer, it is possible to etch off BPSG layer (21) first, and then to etch off underlying MTO layers (20) and (9). Consequently, a fin-shaped, stacked structure can be reliably formed.

As the etching rate for BPSG layer (21) is high, Si₃N₄ layer (8) as the base layer of MTO layer (9) is substantially not etched (in this case, the etching rate of Sb N4 layer is suppressed to about 18 A/min). Consequently, Sb N4 layer (8) can protect the underlying MTO layer (7). This is, it acts as an etching mask (etching stop) for this MTO layer.

Then, as shown in Figure 16, the CVD method is used to deposit a dielectric film on the entire surface. For example, Si₃N₄ film (26) with a thickness of about 60 A is deposited. Then, the Si₃N₄ film is oxidized, and the pinholes are buried by the oxide coating, with the dielectric film forming a fine film.

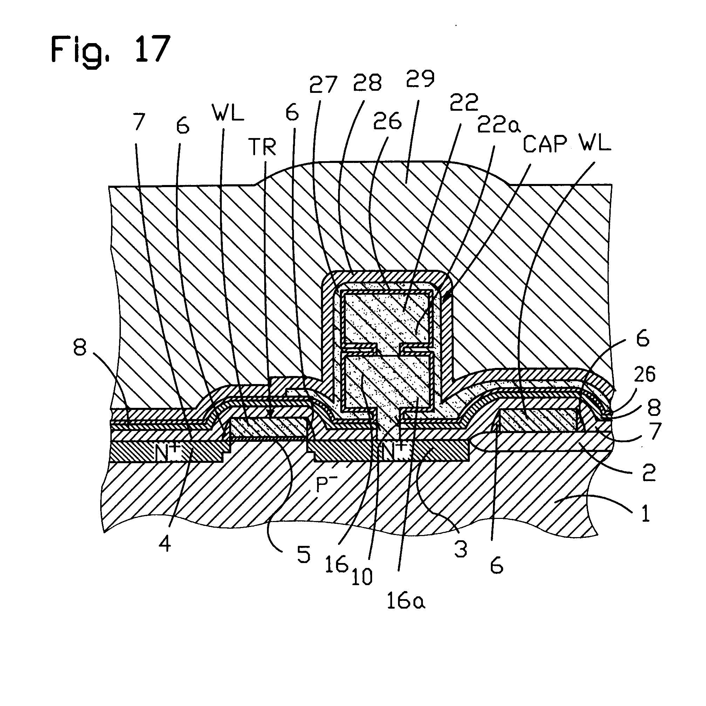

Then, as shown in Figure 17, the CVD method is used to deposit the fourth layer of polysilicon (27) to a thickness of about 700 Â. It is then processed by photoetching to form a pattern of the upper electrode of cell capacitor CAP. Then, an MTO layer (28) with a thickness of about 1000 A and a BPSG layer (29) with a thickness of about 7000 A are deposited on it in order using the CVD method. The BPSG layer is then subject to the same thermal reflow treatment as above. The conditions for depositing MTO layer (28) and BPSG layer (29) are the same as above.

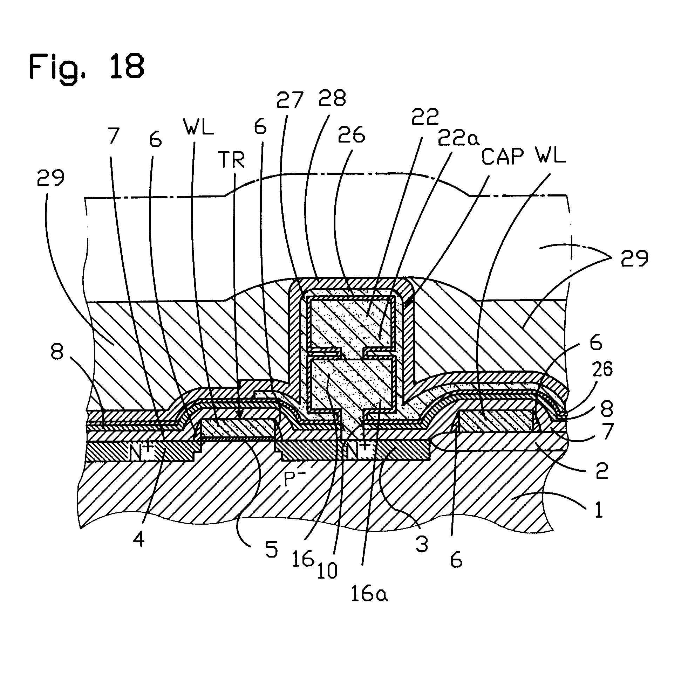

Then, as shown in Figure 18, based on this invention, the aforementioned buffered hydrofluoric acid is used again to perform selective etchback of BPSG layer (29) to the position indicated by the solid line, so that MTO layer (28) is exposed on polysilicon layer (22), and the surface becomes flat. In this case, too, as the surface becomes flat, the subsequent wiring process becomes easier.

In this etchback operation, just as for the etchback operation explained above (see Figure 12), BPSG layer (29) is etched back to the maximum limit to reach the surface of MTO layer (28). For this purpose, the buffered hydrofluoric acid is used based on this invention, and the etching margin is increased by setting the etching rate for BPSG layer (29) to about 1.1-1.2 times that of MTO layer (28).

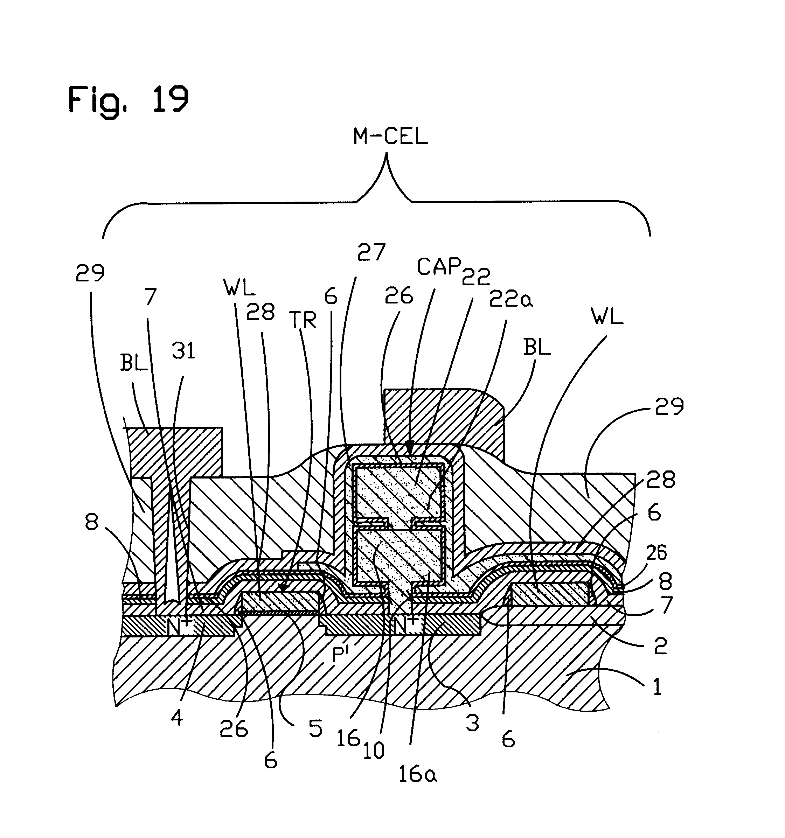

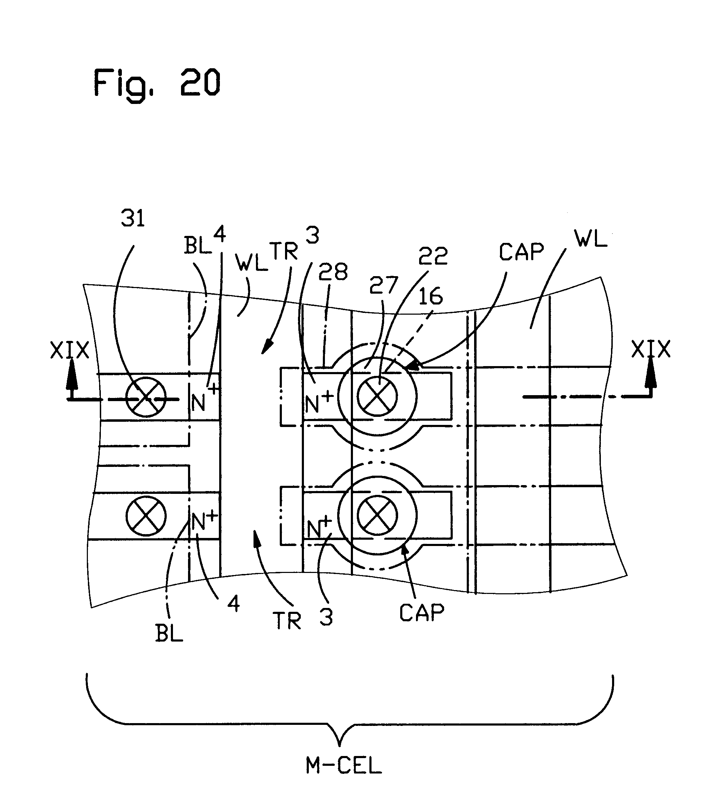

Then, as shown in Figures 19 and 20, a portion of the insulating layers on the n⁺⁻type region (4) is removed by means of photoetching to form contact hole (31), and then, for example, the sputtering method is used to deposit an electroconductive material (such as aluminum) on the entire surface, followed by processing to form the prescribed pattern of bit lines BL. In this way, a dynamic RAM (such as 64M) with memory cells having fin-shaped, stacked cell capacitors CAP incorporated in it is completed.

In this case, when bit lines BL are processed, BPSG layer (29) is etched back well, so that its surface becomes flat. Consequently, the step between MTO layer (28) and BPSG layer (29) can be minimized. In this way, the following good effects can be realized.
(1) In the photoetching (photolithography) performed for processing the bit lines BL, it is possible to improve the quality of processing of the mask (photoresist) and its alignment, to improve the focus depth and resolution in exposure, and to increase the processing margin. Consequently, it is appropriate for micron processing.
(2) When bit lines BL are dry-etched, the step can be minimized. Consequently, the amount of the etching residue left at the step portion can be reduced significantly or entirely eliminated. Consequently, the etching margin can be increased, it is possible to prevent short-circuit between the bit lines, and this facilitates formation of the micron device.
(3) Since BPSG layer (29) can be etched to the maximum limit until the surface of MTO layer (28) is reached, it is possible to reduce the height of bit lines BL (in particular, on the capacitor). Also, it is possible to reduce the depth of contact hole (31), to improve the step coverage in sputtering of the electroconductive material, to improve the contact state, and to increase the margin.

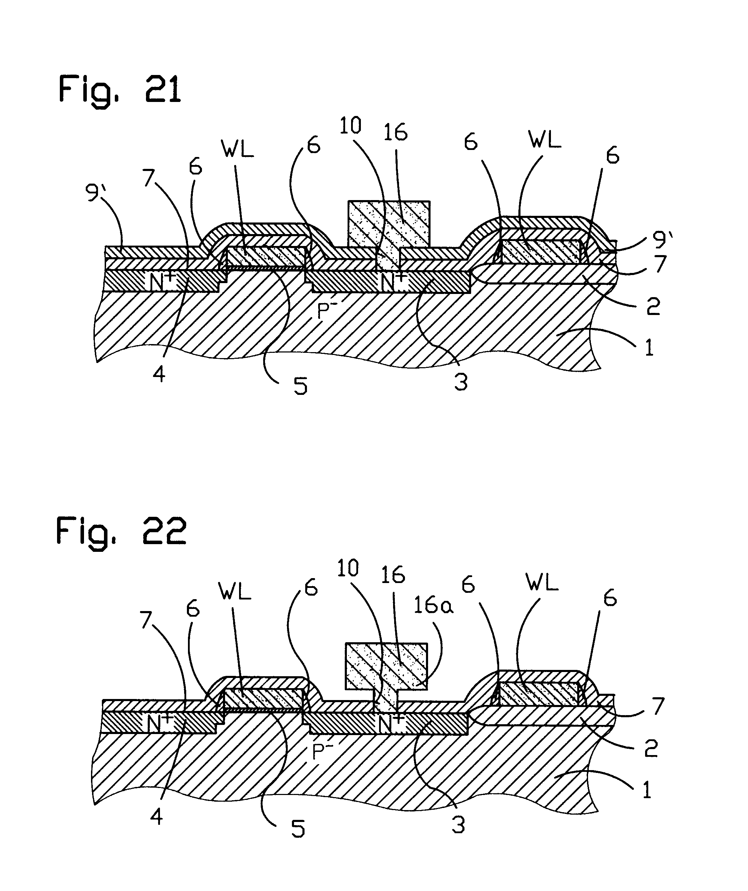

Figures 21-27 are diagrams illustrating another example of the manufacturing method of the memory cells of the dynamic RAM based on this invention. In this example, the same symbols are adopted to designate the same parts as in the example. Therefore, they will not be explained again.

In this example, as shown in Figure 21, MTO layer (7) and MTO layer (9') made by doping 2-4% of phosphorus are laminated in order on silicon substrate (1) in the same way as explained with reference to Figures 9 and 10. (It is possible to form said two layers (7) and (9') in monolayers; also, Sb N4 layer (8) may be formed or not formed.) In contact hole (10) formed on this laminate film, polysilicon layer (16) is formed as the lower electrode of the cell capacitor.

Then, as shown in Figure 22, only MTO layer (9'), which has a higher etching rate than MTO layer (7) due to doping of the impurity, is etched off, so that fin portion (16a) is formed on polysilicon layer (16). In this case, the etching solution used is preferably the etching solution made of the buffered hydrofluoric acid according to this invention (with a low NH4 concentration; for example, with NH₄F = 3 wt% and HF = 6 wt%, or with NH₄F = 3 wt% and HF = 1.6 wt%). Of course, it is possible to use other compositions for the etching solution (such as an etching solution containing only HF).

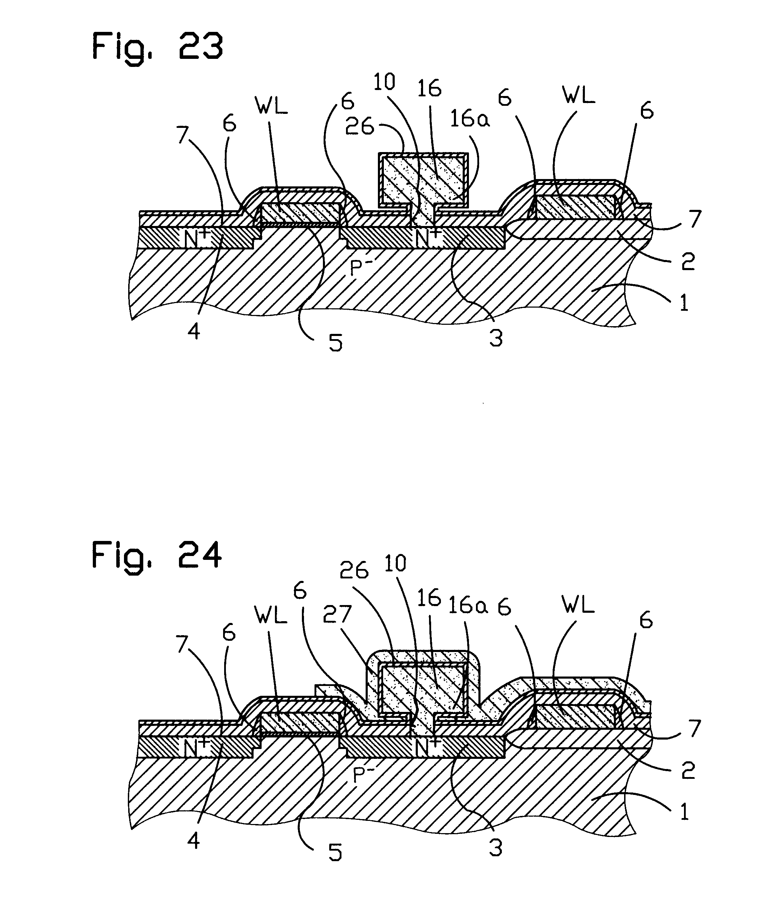

Then, as shown in Figure 23, the CVD method is adopted to coat an Sb N4 dielectric film (26) on the entire surface. Then, as shown in Figure 24, polysilicon layer (27) deposited on the entire surface using the CVD method is subject to photoetching to form a pattern of the upper electrode on the cell capacitor.

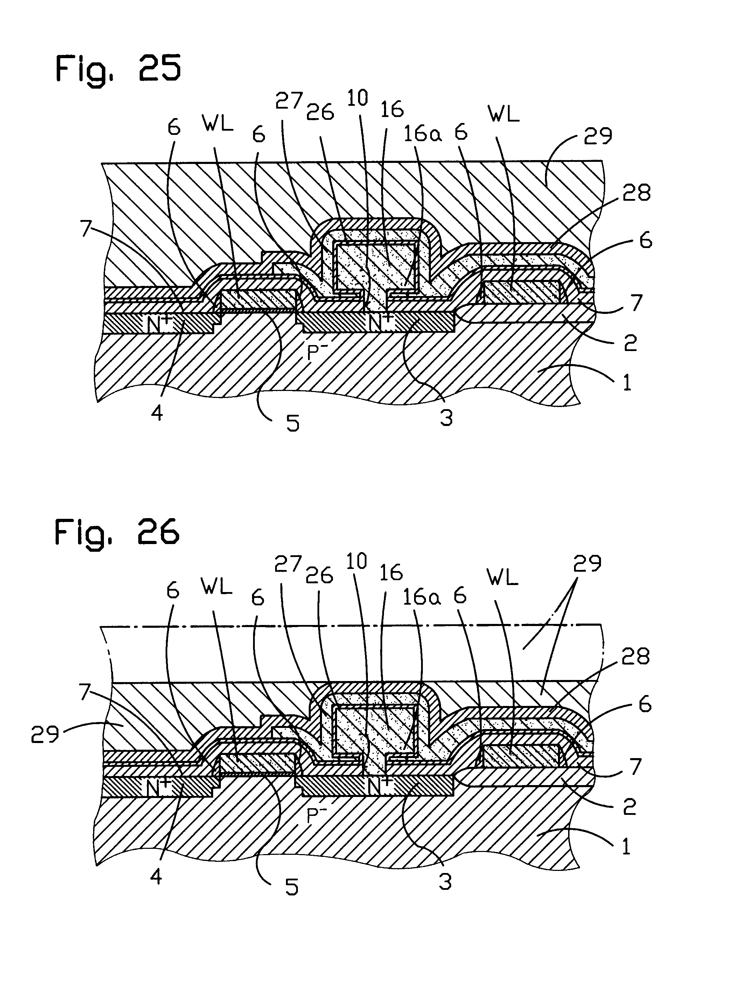

Then, as shown in Figure 25, MTO layer (28) and BPSG layer (29) are deposited on the entire surface. The conditions for depositing these layers are identical to those adopted above.

Then, as shown in Figure 26, in the same way as explained above, buffered hydrofluoric acid (with HF = 6 wt% and NH₄F = 5-6 wt%) based on this invention is used to etchback BPSG layer (29) to the position indicated by the solid line, so that the surface becomes flat, and, at the same time, MTO layer (28) is exposed on polysilicon layer (16).

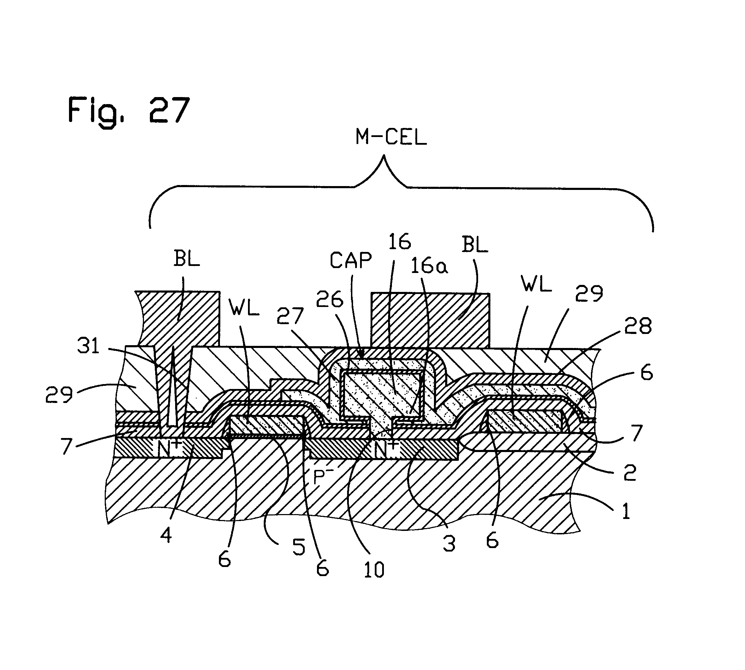

Then, as shown in Figure 27, contact holes (31) are formed on n⁺⁻type region (4), and bit lines BL are coated with the prescribed pattern.

In this example, cell capacitor CAP has a stacked structure, while the lower electrode is formed in the form of a monolayer instead of a fin shape. However, just as in the aforementioned example, in the processing step illustrated in Figure 26, BPSG layer (29) is etched back. Consequently, the same effect with respect to flattening of the surface as described above can be realized.

In the above, this invention was explained with reference to application examples. However, this invention it not limited to these application examples, as variations can be made based on the technological ideas of this invention.

For example, it is possible to change the basic composition of HF and NH4 for the aforementioned buffered hydrofluoric acid over an appropriate range. Also, as a third component, a surfactant can be added in small amounts for reducing the surface tension. Also, it is possible to control the conditions (temperature, time, etc.) for the etching operation.

The etching solution used in this invention is not limited to what was explained in the aforementioned examples. For example, in the etchback processing step shown in Figures 12 and 18, other conventional flattening methods and the buffered hydrofluoric acid and HF with a composition outside of the range of this invention may he adopted. However, at least in the etching processing step shown in Figure 15 (formation of fin-shaped, stacked structure), the buffered hydrofluoric acid of this invention must be used.

Also, the film formation conditions for the interlayer insulating layers with the etching solution of this invention used and the types of materials may be selected appropriately. For example, it is possible to form the MTO layers using the liquid-phase CVD method. Also, it is possible to use oxides other than MTO, and impurity-doped oxides other than BPSG (including those doped with only boron or phosphorus) for forming the insulating layers.

For the aforementioned dielectric film, the materials used may also be changed, and the layer structure may also he changed (in particular, for the cell capacitor portion, the lower electrode may have 3 or more layers, and the shape of the fin may also be changed).

Also, according to this invention, in addition to the aforementioned dynamic RAM having stacked cell capacitors, other structures may be adopted. For example, it is possible to adopt a structure in which the aforementioned stacked cell capacitor is arranged on an Si0₂ film, and the lower electrode of the capacitor is extended to make connection to the source region of a transfer gate. Also, the electroconductive type of the aforementioned semi- conductor region can he changed, or this invention may be adopted for the other portions of the semi- conductor device and for other types of devices.

### Effects of the invention

As explained above, according to this invention, a first insulating layer and a second insulating layer are formed in order on a semiconductor substrate. Of these insulating layers, at least the second insulating layer is etched to manufacture the semiconductor device. In this case, an etching solution containing 1.6-6 wt% of hydrogen fluoride and 2.5-10 wt% of ammonium fluoride is used in the aforementioned etching operation. The etching rate ratio of the first and second insulating layers can he set appropriately, and the various layers can be etched with excellent controllability. In this way, the surface is flat after the etching operation, and the etching operation can be performed in uniform fashion.

### Reference numerals

1, silicon substrate
3, n^{l-}type source region
4, n^{l-}type drain region
7, 9, 20, 28, MTO layer (low-temperature CVD
oxide film)
8, Sb N4 layer
9', doped MTO layer
16, 22, polysilicon layer (lower electrode)
16a, 22a, fin portion
21, 29, BPSG layer (CVD oxide film doped with boron or phosphorus)
21', BL', etching residue
26, dielectric film
27, polysilicon layer (upper electrode)
WL, word line
BL, bit line
CAP, cell capacitor
TR, transfer gate
M-CEL, memory cell

## Claims

1. A method of manufacturing a semi-conductor device where forming a first insulating layer and a second insulating layer in order on a semi-conductor substrate; etching at least the second insulating layer with an etching solution including hydrogen fluoride and ammonium fluoride.

2. The method described in Claim 1, wherein the etching step comprises etching with a solution comprising about 1.6-6 wt% of Hydrogen Fluoride and about 2.5 - 10wt% of Ammonium Fluoride.

3. The method described in Claim 1 or Claim 2, further comprising forming the first insulating layer of silicon oxide grown at a low temperature, and the second insulating layer of silicon oxide containing boron and/or phosphorus.

4. The method described in any preceding claim, further comprising etching the second insulating layer so that its surface becomes flat.

5. The method described in any one of Claims 1-4, further comprising forming a capacitor in a memory cell, forming the first insulating layer as the interlayer insulating film; forming, the second insulating layer on the aforementioned first insulating layer.

6. The method described in Claim 5, further comprising laminating the second electroconductive layer as the lower electrode on the first electroconductive layer so as to form the stacked cell capacitor, and carrying out the following processing steps:-
processing step in which a first insulating layer and a second insulating layer are formed in order on the aforementioned first electroconductive layer;
processing step in which the aforementioned second insulating layer is etched to become flat, while the aforementioned first insulating layer is exposed on the aforementioned first electroconductive layer;
processing step in which the exposed first insulating layer is removed selectively, and the aforementioned second electroconductive layer is formed on the aforementioned removal region;
processing step in which the aforementioned second insulating layer and the aforementioned first insulating layer are etched after the aforementioned processing step;
processing step in which, after the etching operation, a dielectric film is formed on the surface of the aforementioned second electroconductive layer;
processing step in which a third electroconductive layer is formed as the upper electrode on the aforementioned dielectric film;
processing step in which the aforementioned first insulating layer and the aforementioned second insulating layer are formed in order on the aforementioned third electroconductive layer;
and a processing step in which the second insulating layer is etched to become flat.

7. The method described in Claim 5 or Claim 6 further comprising forming the cell capacitor with only the first electroconductive layer used as the lower electrode, by carrying out the following processing steps:-
processing step in which a dielectric film is formed on the aforementioned first electroconductive layer;
processing step in which an upper electrode is formed on the aforementioned dielectric film;
processing step in which the first insulating layer and second insulating layer are formed in order on the aforementioned upper electrode; and a processing step in which the second insulating layer is etched to become flat.

8. The method described in Claim 6 or 7, further comprising forming the cell capacitor in the shape of a fin, and forming the first insulating layer directly beneath the fin portion of the first electroconductive layer.

9. The method described in any one of Claims 6-8 further comprising providing the first electroconductive layer connected to the source region of the memory cell, forming the first insulating layer and second insulating layer on the upper electrode on the drain region of the memory cell, and, on this drain region, forming a contact hole on the insulating layer, including the first insulating layer and second insulating layer.

10. A type of etching solution used at least for etching the second insulating layer in the method described in any one of Claims 1-9, and comprising about 1.6-6 wt% of hydrogen fluoride and about 2.5-10 wt% of ammonium fluoride.

11. A semi-conductor device formed in accordance with the method of any of claims 1 to 9.

12. A semi-conductor device of Claim 11, in the form of a memory device.

13. A memory device including a semi-conductor device according to Claim 11.

14. A memory device according to Claim 13, including a stacked capacitor.
